# EUROPEAN PATENT APPLICATION

(11) **EP 0 878 985 A2**
(43) Date of publication of application: **18.11.1998**
(21) Application number: 98108537.6
(22) Date of filing: 11.05.1998
(51) Int. Cl.: H05K 3/32, H01G 4/232, H01G 2/06

(54) **Electronic part for mounting on a substrate**

(30) Priority: 12.05.1997 JP 120771/97
(71) Applicant: MURATA MANUFACTURING CO., LTD., Nagaokakyo-shi Kyoto-fu (JP)
(72) Inventor: Ikeda, Haruhiko, Nagaokakyo-shi, Kyoto-fu (JP)
(74) Representative: Gossel, Hans K., Dipl.-Ing.

(57) **Abstract**

The invention provides an electronic part for mounting on a substrate, comprising at least one terminal electrode which is coated with a functional group having a nucleophilic substituting property, wherein on the functional group an adhesive is applied by interatomic bonding.

The invention also provides a method of mounting the electronic part.

According to the invention the bonding strength between an electronic part and a substrate is improved by not only mechanical bonding but also chemical bonding.

## Description

### BACKGROUND OF THE INVENTION

### 1. Technical Field of the Invention

The present invention relates to an electronic part for mounting on a substrate. The present invention further relates to a method of mounting the electronic part.

### 2. Related Art of the Invention

In the case of mounting an electronic part on a substrate, soldering has been widely used. To improve the soldering property, to an external electrode of the electronic part a treatment of a soft solder, tin plating, gold plating, etc., is applied.

Recently, there is a tendency of not using a soft solder containing lead. For the purpose, an electrically conductive adhesive instead of the soft solder is used to mount the electronic part on the substrate.

However, because a conventional surface treatment i.e., soft solder, tin plating, gold plating, etc. is performed on external electrodes of the electronic part, bonding between the electrically conductive adhesive and the external electrode is mechanical bonding only by an anchor effect. Therefore, the bonding strength of the substrate and the electronic part is relatively weak.

### SUMMERY OF THE INVENTION

An object of the present invention is to provide an electronic part for mounting on a substrate wherein the bonding strength between the electronic part and the substrate after soldering is improved.

This object is solved by an electronic part (3) for mounting on a substrate (7), comprising at least one terminal electrode (5) which is coated with a functional group having a nucleophilic substituting property, wherein on the functional group an adhesive (11) is applied by interatomic bonding.

By interatomic bonding between the functional group having a nucleophilic substituting property in the terminal electrode and the functional group of a resin in the adhesive, not only mechanical bonding by an anchor effect only as a conventional case but also chemical bonding is added. Thus, the bonded strength of the electronic parts and the substrate is far more improved.

According to a preferred embodiment said functional group having the nucleophilic substituting property may be a hydroxy radical. By interatomic bonding (hydrogen bonding) between the hydroxy radical and the functional group of a resin in the adhesive, the effect as described above is obtained.

According to a preferred embodiment said adhesive may include an epoxy series resin. By interatomic bonding between the functional group (hydroxy radical) having the nucleophilic property in the terminal electrode and the epoxy group in the adhesive, the above-described effect is obtained. Furthermore, said adhesive may be an electrically conductive adhesive including an electrically conductive powder.

Another aspect of the present invention provides a method of mounting an electronic part, comprising the steps of:
1) preparing an electrically conductive paste comprising an electrically conductive powder, a photocatalyst, and an organic vehicle;
2) coating said electrically conductive paste on an electronic part element;
3) irradiating said terminal electrode with a radiation;
4) coating an adhesive on said terminal electrode; and
5) mounting said electronic part on a substrate (7) by soldering.

By irradiating the terminal electrode including the photocatalyst with the radiation, a functional group enriched with a nucleophilic substituting property is formed on the surface of the terminal electrode and by interatomic bonding between the functional group and a functional group of a resin in the adhesive, the above-described effect is obtained.

In the above described method, said photocatalyst may be anatase-type TiO₂.

The use of anatase-type TiO₂ is effective in the point that the method can be safely and easily realized.

In the above described method, said radiation may be an ultraviolet ray. The use of ultraviolet rays is effective in the point capable of efficiently and safely irradiating.

According to a preferred embodiment the coating of said electrically conductive paste is performed by sintering.

### BRIEF DESCRIPTION OF THE DRAWINGS

- Fig. 1: is a side view showing a mounting structure of an electronic part, which is an example of the present invention.
- Fig. 2: is a schematic view of an external electrode of an electronic part, which is an example of the present invention.
- Fig. 3: is a schematic view of an external electrode of an electronic part, which is an example of the present invention.
- Fig. 4: is a schematic view of an external electrode and an electrically conductive adhesive of an electronic part, which is an example of the present invention.

### PREFERRED EMBODIMENTS OF THE PRESENT INVENTION

Other features and advantages of the present invention will become apparent from the following description of the invention which refers to the accompanying drawings.

The kind of the electronic part is not always restricted. Practically, there are, for example, laminated condensers, semiconductor elements, elastic surface wave elements, resonators, oscillators, thin film circuit elements, and the like.

The terminal electrode of an electronic part includes, for example, an external electrode of an laminated condenser and a wiring circuit of a semiconductor element.

The substrate means lands, base plates, lead frames, metal plates, etc.

The adhesive may be an electrically conductive adhesive or an insulating adhesive. Also, a resin alone can be used as the adhesive.

The functional group having a nucleophilic substituting property means a functional group having a tendency of giving an electron to another functional group, such as OH⁻, RO⁻ (wherein R is CH₃, and the like), CN⁻, F⁻, Cl⁻, Br⁻, I⁻, etc.

The photocatalyst is not always restricted as long as the catalyst forms a radical functional group by the irradiation of a radiation. Typical example is anatase-type TiO₂.

As the electrically conductive powder, various powders such as Ag/Pd, Cu, Ag, etc., can be used.

Then, the present invention is more practically explained but the invention is not limited to the example.

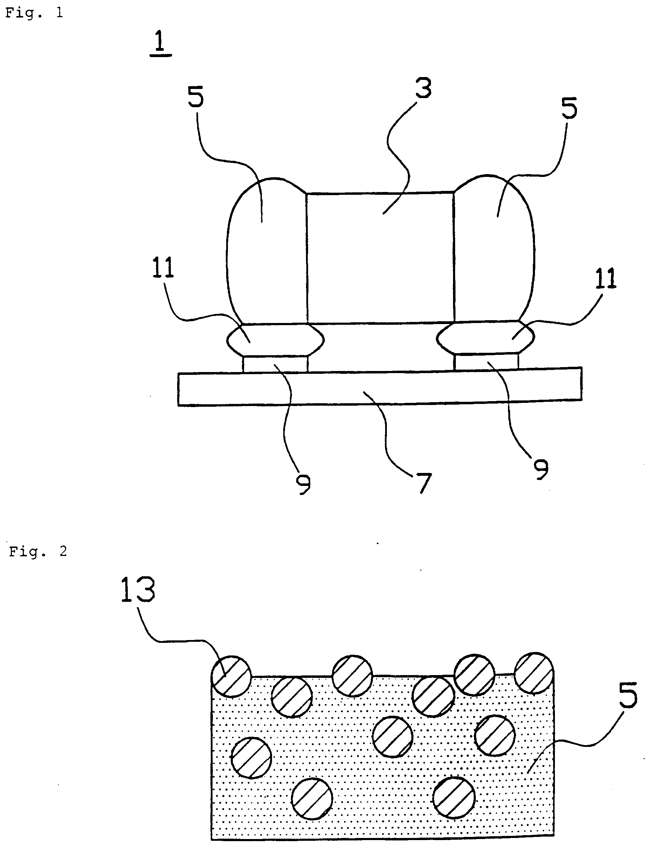

Fig. 1 is a side view showing a mounting structure of electronic parts, which is an example of the present invention.

As shown in Fig. 1, a mounting structure 1 of a laminated condenser which is an electronic part is composed of an electronic part element 3 made up of a ceramic material, external electrodes 5 (terminal electrodes) formed at both ends of the electronic part element 3, a wiring base plate 7 (substrate) made up of a glass epoxy material, wiring electrodes 9 formed on the wiring base plate 7, and an epoxy series electrically conductive adhesive 11 (adhesive) connecting the external electrodes 5 to the wiring electrodes 9. In addition, not shown in the figure, internal electrode layers to be connected to the external electrode 5 are alternately laminated via ceramic layers in the inside of the electronic part element 3.

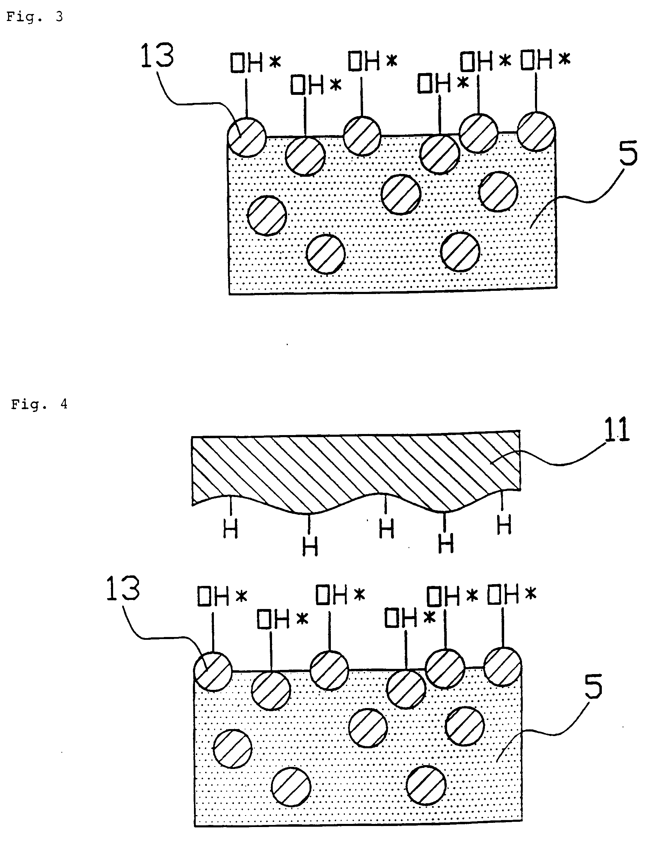

Then, a mounting method of electronic parts, which is an example of the present invention, is explained. Fig 2 to Fig. 4 are schematic views showing the external electrode of the electronic part and the electrically conductive adhesive.
(1) First, an electrically conductive paste is prepared by mixing an Ag/Pd powder, anatase-type TiO₂ 13 (photocatalyst), and an organic vehicle. In addition, if necessary, a glass frit may be added.
(2) Then, the electrically conductive paste is coated on both end portions of the electronic part element 3 after sintering by a dipping method and thereafter the element is dried and burned to form the external electrodes 5 (Fig. 2).
(3) Thereafter, by irradiating the external electrodes 5 with ultraviolet rays, anatase-type TiO₂ 13 on the surface of the external electrodes 5 acts as a photocatalyst. That is, adsorbed water (moisture is air) attached on the surface of the external electrodes reacts with the positive holes of anatase-type TiO₂ 13 to form hydroxy radicals (OH*)(Fig. 3).
(4) Then, an electrically conductive adhesive 11 is coated on the external electrodes 5. In this case, the epoxy group in the electrically conductive adhesive 11 causes hydrogen bonding with the hydroxy radical (OH*) of the external electrode 5 to form strong bonding (Fig. 4).
(5) Also, the external electrodes 5 are connected to the wiring electrodes 9 via the electrically conductive adhesive 11 to mount the electric part on the wiring base plate 7.

While the invention has been particularly shown and described with reference to preferred embodiments thereof, it will be understood by those skilled man in the art that the forgoing and other changes in form and details may be made therein without departing from the spirit of the invention.

## Claims

1. Electronic part (3) for mounting on a substrate (7), comprising at least one terminal electrode (5) which is coated with a functional group having a nucleophilic substituting property, wherein on the functional group an adhesive (11) is applied by interatomic bonding.

2. Electronic part (3) according to claim 1, characterized in that said functional group having the nucleophilic substituting property is a hydroxy radical.

3. Electronic part (3) according to claim 1 or 2, characterized in that said adhesive (11) includes an epoxy series resin.

4. Electronic part (3) according to one of claims 1 to 3, characterized in that said adhesive (11) is an electrically conductive adhesive including an electrically conductive powder.

5. Method of mounting an electronic part, comprising the steps of:
1) preparing an electrically conductive paste comprising an electrically conductive powder, a photocatalyst, and an organic vehicle;
2) coating said electrically conductive paste on an electronic part element (3);
3) irradiating said terminal electrode (5) with a radiation;
4) coating an adhesive (11) on said terminal electrode (5); and
5) mounting said electronic part on a substrate (7) by soldering.

6. Method according to claim 5, characterized in that said photocatalyst is anatase-type TiO₂.

7. Method according to claim 5 or 6, characterized in that said radiation is an ultraviolet ray.

8. Method according to one of the claims 5 to 7, characterized in that the coating of said electrically conductive paste is performed by sintering.
